# EUROPÄISCHE PATENTSCHRIFT

(11) **EP 0 899 882 B1**
(45) Veröffentlichungstag und Bekanntmachung des Hinweises auf die Patenterteilung: **29.01.2003**
(21) Anmeldenummer: 98111896.1
(22) Anmeldetag: 26.06.1998
(51) Int. Cl.: H03K 17/955

(54) **Schaltungsanordnung für einen kapazitiven Schalter**
Circuit arrangement for a capacitive switch
Circuit pour un interrupteur capacitif de proximité

(30) Priorität: 26.06.1997 DE 19727220
(43) Veröffentlichungstag der Anmeldung: 03.03.1999
(73) Patentinhaber: captron electronic gmbh, 81243 München (DE)
(72) Erfinder: Bellm, Reinhard, 82110 Germering (DE); Thiessen, Rainer, Dr., 80686 München (DE)
(74) Vertreter: Strasser, Wolfgang, Dipl.-Phys

(56) Entgegenhaltungen:
- EP-A- 0 341 576
- EP-A- 0 766 398
- US-A- 4 760 490
- ELEKTOR ELECTRONICS,Dezember 1996, Seiten 94-95, XP000680838

## Beschreibung

Die Erfindung betrifft eine Schaltungsanordnung für einen kapazitiven Schalter.

Bei herkömmlichen kapazitiven Schaltern ist ein Oszillator mit einer im allgemeinen durch eine dünne Isolatorschicht abgedeckten Flächenelektrode gekoppelt, deren Kapazität gegen Erde sich ändert, wenn ein geerdeter Körper in ihre Nähe kommt oder sie berührt.

Nach dem Stand der Technik wird diese Kapazitätsänderung in der Weise erfaßt, daß ein nicht schwingender Oszillator durch sie zum Anschwingen gebracht oder ein schwingender Oszillator so stark bedämpft wird, daß seine Schwingung abreißt. Beide Vorgehensweisen sind nachteilig, da im erstgenannten Fall beispielsweise beim Testen und der Qualitätssicherung nur sehr schwer festgestellt werden kann, wie nahe sich der nicht schwingende Oszillator am Anschwingen befindet, und sich im anderen Fall zeigt, daß ein Oszillator, dessen Schwingung bei kapazitiver Bedämpfung abreißt, in einem sehr instabilen Betriebszustand arbeitet, der leicht zu Störungen führt.

Aus der US 4 760 490 A ist ein kapazitiver Schalter bekannt, dessen Schaltungsanordnung einen permanent schwingenden Oszillator umfaßt, dessen Ausgangssignal über ein Netzwerk einerseits einer Elektrodenplatte und andererseits dem Eingangsverstärker einer nachfolgenden Auswerte- und Schaltelektronik zugeführt wird. Nähert sich ein Körper an die Elektrodenplatte an, so ändern sich aufgrund der hierdurch bedingten Kapazitätsänderung die Widerstandsverhältnisse im Netzwerk, wodurch die Amplitude des dem Eingangsverstärker zugeführten Signals abnimmt Eine optimale Rückwickungsfreiheit der Verbindung zwischen Elektrodenplatte und Oszillator ist dabei nicht gegeben.

Der Erfindung liegt die Aufgabe zugrunde, einen kapazitiven Schalter und seine Schaltungsanordnung so auszulegen, daß sie über einen weiten Temperaturbereich verwendbar sind, hohe Langzeitstabilität und gute Testbarkeit aufweisen und gegen von außen kommende Störstrahlung unempfindlich sind.

Zur Lösung dieser Aufgabe sieht die Erfindung die im Anspruch 1 zusammengefaßten Merkmale vor.

Gemäß der Erfindung wird ein konstant schwingender Oszillator verwendet, dessen Ausgang über eine als Impedanzwandler dienende Treiberstufe rückwirkungsfrei mit der Flächenelektrode gekoppelt ist. Damit wird der Oszillator von der Meßgröße, das heißt der Kapazitätsänderung der Flächenelektrode bzw. dem auf sie fließenden Verschiebestrom nicht beeinflußt, und es können keine von außen kommenden Störungen und insbesondere elektrostatischen Entladungen an den hochempfindlichen Oszillator gelangen.

Der Oszillator kann eine Sinus-Schwingung erzeugen. Dies hat den Vorteil, daß die Störungsaussendung durch Oberwellen gering ist. Wenn diese Eigenschaft nicht von entscheidender Bedeutung ist, kann auch ein Rechteck-Oszillator verwendet werden.

Für den Fall, daß die zur Betätigung des kapazitiven Schalters dienende Flächenelektrode im Freien, beispielsweise an der Außenseite einer Straßenbahn oder eines Omnibus angebracht werden muß, ist es vorteilhaft, um die Flächenelektrode herum eine Ringelektrode vorzusehen, die auf dem gleichen Wechselspannungspotential gehalten wird, wie die Flächenelektrode. Dadurch wird die Problematik vermindert, daß Regen- oder Spritzwasser, das über die Abdeckung der Flächenelektrode läuft, durch Ladungstransport ein fehlerhaftes Schalten verursachen kann.

Gemäß einer bevorzugten Ausführungsform ist vorgesehen, daß die Ringelektrode nicht nur zur Abschirmung der Flächenelektrode dient, sondern daß zur Erzeugung eines Schalter-Betätigungssignals die Differenz der auf die beiden Elektroden fließenden Verschiebeströme gemessen wird. Dadurch wird die Grundkapazität der beiden Elektroden gegenüber ihrer Einbauumgebung in ihrem Einfluß auf das Meßsignal ebenso vermindert, wie eine Vorbedämpfung des Schalters beispielsweise durch Eis oder Schmutz. Auch der Einfluß von von außen kommenden Störungen wird durch die Differenzbildung reduziert.

Vorzugsweise werden die Treiberstufen so aufgebaut, daß sie beim Fließen eines Verschiebestroms auf die zugehörige Elektrode ohne aufwendige Demodulation ein Halbwellensignal liefern, das ohne weiteres geglättet werden kann, um ein Gleichspannungssignal zu erhalten, das sich nur bei Annäherung eines geerdeten Körpers an die betreffende Elektrode ändert.

Dieses Gleichspannungssignal wird mit Hilfe eines Hochpasses gefiltert, der nur die Änderung des Signals durchläßt. Dadurch wird die Grundkapazität der Elektroden eliminiert, die in Abhängigkeit von der Einbauform sehr unterschiedliche Werte annehmen kann. Auch die durch Eis oder Tau entstehende zusätzliche kapazitive Kopplung gegen die Wand eines Fahrzeuges kann auf diese Weise unschädlich gemacht werden.

Somit wird es möglich, den kapazitiven Schalter universell zu verwenden, da beispielsweise eine Montage hinter einer Glasscheibe eine völlig andere Grundkapazität gegen Erde mit sich bringt, als eine außenseitige Montage auf einer Fahrzeugkarosserie.

Mit Hilfe eines weiterhin vorgesehenen Tiefpaßfilters können auf das Meßsignal aufgeprägte Störspitzen unterdrückt werden.

Diese und weitere vorteilhafte Ausgestaltungen der erfindungsgemäßen Schaltungsanordnung sind in den Unteransprüchen niedergelegt

Die Erfindung wird im folgenden anhand von Ausführungsbeispielen unter Bezugnahme auf die Zeichnung beschrieben; in dieser zeigen:
- Fig.1: ein schematisches Schaltungsdiagramm einer erfindungsgemäßen Schaltungsanordnung für einen kapazitiven Schalter,
- Fig.2: eine erste Ausführungsform der Treiberschaltung aus Fig.1 für einen kapazitiven Schalter, bei der nur der Verschiebestrom auf die Flächenelektrode zur Gewinnung des Schaltsignals ausgewertet wird,
- Fig.3: eine zweite Ausführungsform der Treiberschaltung aus Fig.1, bei der sowohl der Verschiebestrom auf die Flächenelektrode als auch der Verschiebestrom auf die Ringelektrode zur Gewinnung des Schaltsignals ausgewertet wird,
- Fig.4: eine erste als Gegentaktschaltung aufgebaute Variante der in den Fig.2 und 3 gezeigten Treiberstufen,
- Fig.5: eine zweite mit Hilfe eines Operationsverstärkers realisierte Variante der Treiberstufen aus den Fig.2 und 3 und
- Fig.6: eine Draufsicht auf einen mit einer erfindungsgemäßen Schaltungsanordnung ausgerüsteten kapazitiven Schalter, wie er sich einer Bedienungsperson darstellt.

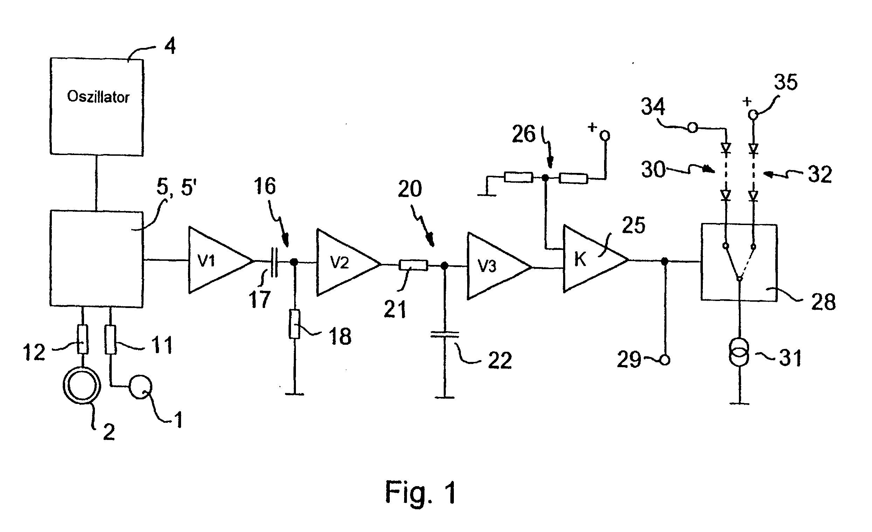

In Fig.1 sind die Flächenelektrode 1 und die Ringelektrode 2 eines kapazitiven Schalters der Deutlichkeit halber nebeneinander dargestellt, obwohl in Wirklichkeit die Ringelektrode 2 die Flächenelektrode 1 konzentrisch umschließt.

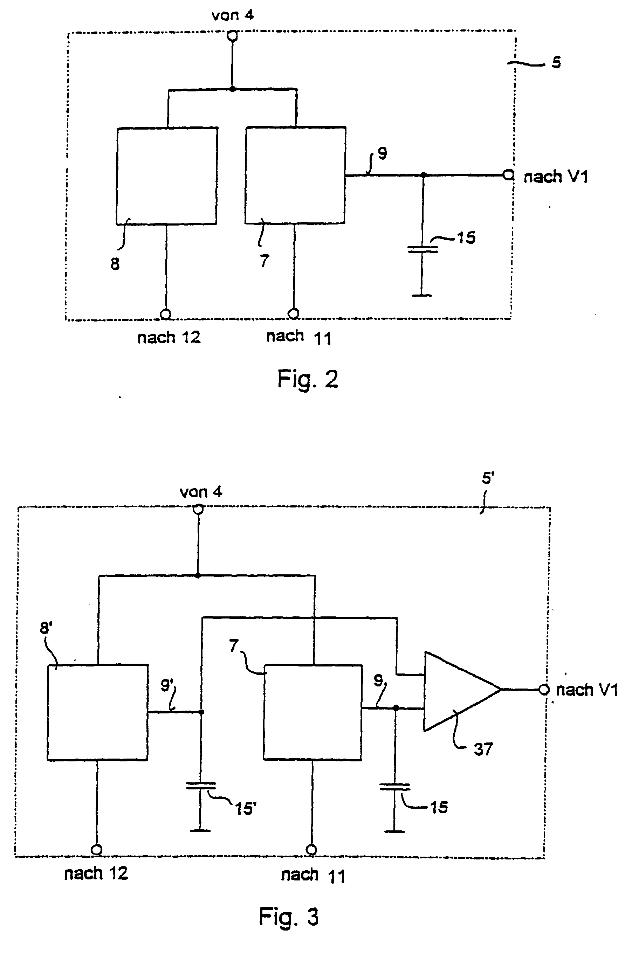

Das Ausgangssignal eines Oszillators 4 wird einer Treiberschaltung 5 zugeführt, die, wie die Fig.2 und 3 zeigen, für jede der beiden Elektroden 1, 2 eine eigene Treiberstufe 7, 8 beziehungsweise 7, 8' umfaßt, deren Ausgang mit der zugehörigen Elektrode 1 beziehungsweise 2 über einen Vorwiderstand 11, 12 verbunden ist, der die Treiberstufe 7, 8 beziehungsweise 7, 8' gegen elektrostatische Entladungen schützt. Somit liegt das Sinus- oder Rechteckssignal des Oszillators 4 an den Elektroden 1 und 2, auf die im eingeschwungenen Zustand nur der Grundbedämpfung entsprechende Verschiebeströme fließen, solange sich kein geerdeter Körper in ihrer unmittelbaren Nähe befindet.

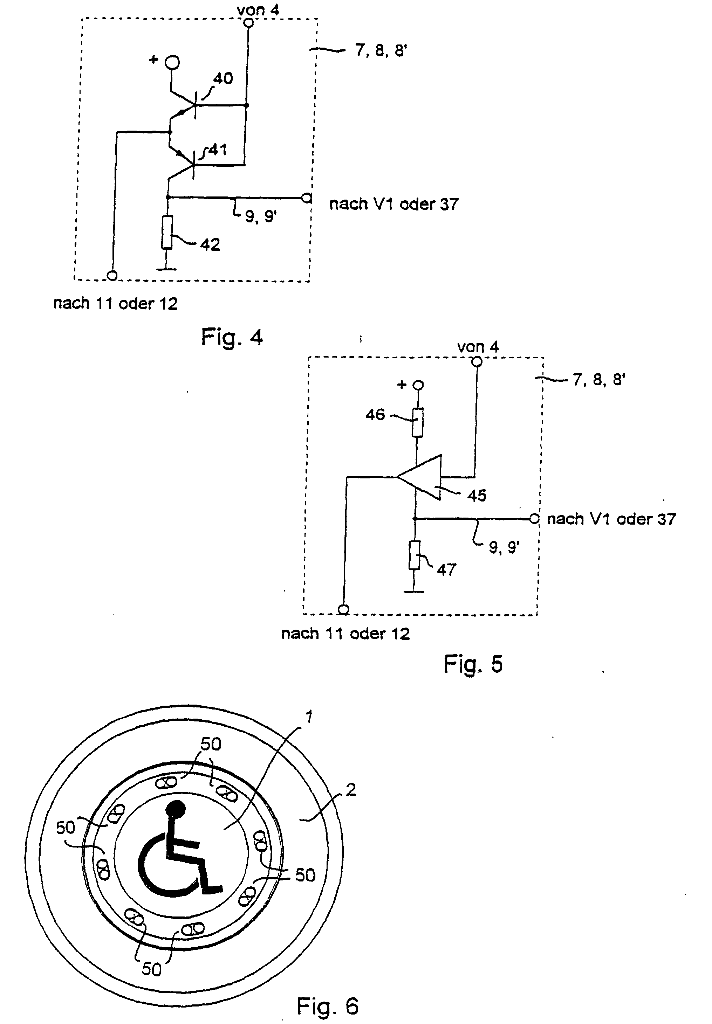

Wie Fig.2 zeigt, besitzt zumindest die Treiberstufe 7 einen weiteren Ausgang 9, an dem, wie weiter unten unter Bezugnahme auf die Fig.4 und 5 noch genauer erläutert wird, ein Halbwellensignal erscheint, wenn auf die zugehörige Flächenelektrode 1 ein Verschiebestrom fließt, weil sich ihr ein geerdeter Körper, beispielsweise die Hand einer den kapazitiven Schalter betätigenden Person so weit genähert hat, daß sich die Kapazität der Flächenelektrode 1 wesentlich verändert. Zwischen diesen weiteren Ausgang 9 der Treiberstufe 7 und Masse ist ein Kondensator 15 geschaltet, der das Halbwellensignal weitgehend glättet, bevor es (siehe Fig.1) einem ersten Verstärker V1 zugeführt wird.

Das Ausgangssignal des Verstärkers V1 wird einem Hochpaßfilter 16 zugeführt, das einen zwischen den Ein- und den Ausgang des Filters 16 gelegten Kondensator 17 und einen den Ausgang mit Masse verbindenden Widerstand 18 umfaßt. Der Ausgang des Hochpaßfilters 16 ist mit dem Eingang eines Verstärkers V2 verbunden, dessen Ausgang ein Tiefpaßfilter 20 ansteuert, zwischen dessen Ein- und Ausgang ein Widerstand 21 liegt und dessen Ausgang über einen Kondensator 22 mit Masse verbunden ist.

Das Ausgangssignal des Tiefpaßfilters 20 wird einem Verstärker V3 zugeführt, dessen Ausgang mit dem einen Eingang eines Komparators 25 verbunden ist, an dessen anderen Eingang mit Hilfe eines Spannungsteilers 26 eine Referenzspannung angelegt ist.

Wenn eine Person den kapazitiven Schalter durch Annähern der Hand an die Flächenelektrode 1 betätigt, überschreitet das vom Verstärker V3 gelieferte Ausgangssignal die Referenzspannung am zweiten Eingang des Komparators 25 und dieser gibt über den Ausgang 29 ein Schaltsignal ab, das einer weiteren Verwendung, beispielsweise zum Öffnen einer Tür zugeführt werden kann.

Außerdem wird, wie Fig.1 zeigt, dieses Schaltsignal einem Umschalter 28 zugeführt, der daraufhin aus seiner in Fig.1 wiedergegeben Ruhestellung, in der er eine Reihenschaltung von grün leuchtenden Leuchtdioden 30 mit einer Stromquelle 31 verbindet, in seine durch gestrichelte Linien wiedergegebene Arbeitsstellung übergeht, in welcher er eine Reihenschaltung von rot leuchtenden Leuchtdioden 32 mit der Stromquelle 31 verbindet.

Die Reihenschaltung der grün leuchtenden Leuchtdioden 30 ist mit ihrem dem Umschalter 28 gegenüberliegenden Anschluß 34 mit einer Steuereinrichtung (nicht dargestellt) verbunden, mit deren Hilfe sie auf +-Potential gelegt werden kann, so daß beispielsweise beim Einsatz in einer Straßenbahn die grünen Leuchtdioden 30 erst kurz vor Erreichen einer Haltestelle aufleuchten. Demgegenüber ist die Reihenschaltung der roten Leuchtdioden 32 mit ihrem dem Umschalter 28 gegenüberliegenden Anschluß 35 permanent mit +-Potential verbunden, so daß sie sofort aufleuchten, wenn der Umschalter 28 aufgrund eines vom Komparator 25 abgegebenen Schaltsignals aus seiner Ruhestellung in die Arbeitsstellung übergeht. Da hierdurch die grünen Leuchtdioden 30 von der Stromquelle 31 getrennt werden, verlöschen sie.

In Fig. 3 ist eine zweite Variante 5' der Treiberschaltung wiedergegeben, die zum Einsatz kommt, wenn die Differenz der auf die Flächenelektrode 1 und die Ringelektrode 2 fließenden Verschiebeströme zur Erzeugung eines Schaltsignals ausgewertet werden soll.

Wie man der Fig.3 entnimmt, umfassen hier beide Treiberstufen 7, 8', deren Eingänge wieder vom Oszillator 4 angesteuert werden neben dem die zugehörige Elektrode ansteuernden Ausgang einen weiteren Ausgang 9, 9', an welchem ein Halbwellensignal dann erscheint, wenn auf die Flächenelektrode 1 und die Ringelektrode 2 jeweils ein Verschiebestrom fließt, wenn sich ein geerdeter Körper den beiden Elektroden genügend weit genähert hat. Diese Halbwellensignale werden durch die zwischen den weiteren Ausgang 9 bzw.9' der Treiberstufen 7 bzw. 8' und Masse geschalteten Kondensatoren 15, 15' geglättet und den beiden Eingängen eines Differenzverstärkers 37 zugeführt, der die Differenz der beiden Halbwellensignale verstärkt und an den Eingang des Verstärkers V1 (siehe Fig.1) weitergibt

Fig.4 zeigt eine erste Ausführungsform einer Treiberstufe, die sowohl zur Ansteuerung der Flächenelektrode 1 als auch der Ringelektrode 2 verwendet werden kann. Diese Treiberstufe besteht im wesentlichen aus zwei bipolaren Transistoren 40, 41 entgegengesetzter Polarität, deren Emitter miteinander verbunden sind, während der Kollektor des einen Transistors 40 an +-Potential gelegt ist und der Kollektor des anderen Transistors 41 über einen Widerstand 42 mit Masse verbunden ist. An die Basis-Anschlüsse der Transistoren 40, 41 ist das Oszillatorsignal gelegt und der Verbindungspunkt ihrer Emitter dient als Ausgang, der über einen Schutzwiderstand 11 oder 12 die Flächenelektrode 1 oder die Ringelektrode 2 ansteuern kann.

Der Verbindungspunkt zwischen dem Widerstand 42 und dem Kollektor des Transistors 41 dient als weiterer Ausgang 9 bzw. 9', an dem das oben erwähnte Halbwellensignal erscheint, wenn auf die betreffende Elektrode 1 oder 2 ein Verschiebestrom fließt. Bei letzterem handelt es sich zwar um einen Wechselstrom, doch ist wegen der gleichrichtenden Wirkung der beiden Transistoren 40, 41 am Widerstand 42 ein "gleichgerichtetes" Halbwellensignal abgreifbar, das wie erwähnt, durch den außerhalb der Treiberstufe mit ihrem weiteren Ausgang 9, 9' verbundenen Kondensator 15 bzw. 15' weitgehend geglättet wird. Soll diese Treiberstufe gemäß Fig.2 als Treiberstufe 8 zur Ansteuerung der Ringelektrode 2 verwendet werden, ohne daß deren Verschiebestrom berücksichtigt wird, so bleibt der Aufbau unverändert und es wird lediglich die beim Fließen eines Verschiebestroms am Widerstand 42 abfallende Spannung nicht ausgewertet bzw. der Widerstand 42 ganz weggelassen.

Fig.5 zeigt eine Form einer Treiberstufe, die ebenfalls sowohl als Treiberstufe 8 mit nur einem Ausgang oder Treiberstufe 7 beziehungsweise 8' mit zwei Ausgängen Verwendung finden kann. Als aktives Bauelement findet hier ein Operationsverstärker 45 Verwendung, dessen Stromversorgungsanschlüsse über entsprechende Widerstände 46 beziehungsweise 47 an +-Potential bzw. Masse gelegt sind. Dem Eingang des Operationsverstärkers 45 wird das Signal des Oszillators 4 zugeführt und sein Ausgang steuert über den entsprechenden Schutzwiderstand 11 bzw. 12 die Flächenelektrode 1 bzw. die Ringelektrode 2 an. Soll diese Treiberstufe so verwendet werden, daß der auf die betreffende Elektrode 1 oder 2 fließende Verschiebestrom ausgewertet wird, so dient der Verbindungspunkt zwischen dem Widerstand 47 und dem entsprechenden Stromversorgungs-Eingang des Operationsverstärkers 45 als weiterer Ausgang 9 bzw. 9'. Auch hier tritt eine gleichrichtende Wirkung auf, so daß an diesem Ausgang ein leicht glättbares Halbwellensignal erscheint, wenn ein Verschiebestrom auf die zugehörige Elektrode 1 oder 2 fließt. Soll bei Ansteuerung der Ringelektrode 2 der Verschiebestrom nicht ausgewertet werden, so kann auch hier der Widerstand 47 weggelassen werden.

Gegenüber der mit Transistoren aufgebauten Ausführungsform nach Fig.4 bietet dies den Vorteil, daß der als Spannungsfolger verwendete Operationsverstärker 45 langsamer ist als die Transistoren 40, 41 und somit gegen hochfrequente Störungen eine geringere Empfindlichkeit besitzt. Auch hier ist keine gesonderte Demodulation erforderlich und die hochfrequenten Störungen können durch den Kondensator 15 bzw. 15' (siehe Fig.3) gedämpft werden.

Die beschriebene Anordnung arbeitet in folgender Weise: Der Oszillator 4 schwingt während des Betriebs permanent und weder seine Frequenz noch seine Schwingungsamplitude werden durch Kapazitätsänderungen der Elektroden 1, 2 beeinflußt, da er von diesen Elektroden durch die unter anderem auch als Impedanzwandler dienenden Treiberstufen 7, 8 beziehungsweise 7, 8' entkoppelt ist, die die Elektroden 1, 2 niederohmig ansteuern.

Bei dem Ausführungsbeispiel gemäß Fig.1 in Verbindung mit Fig.2 wird nur der bei Annäherung eines geerdeten Körpers an die beiden Elektroden 1, 2 auf die Flächenelektrode 1 fließende Verschiebestrom ausgewertet. Die wesentliche Funktion der Ringelektrode 2 besteht hier darin, einen Ladungstransport durch Regen- oder Spritzwasser zu vermeiden, der bei der Montage der Flächenelektrode 1 an der Außenseite eines Fahrzeugs zu einem fehlerhaften Schalten führen könnte. Die die Flächenelektrode 1 umgebende Ringelektrode 2, die auf dem gleichen Wechselspannungspotential wie die Flächenelektrode 1 gehalten wird, übt dadurch eine abschirmende Wirkung aus, daß sie die Feuchtigkeitströpfchen, die an der Fahrzeugaußenseite zur Flächenelektrode 1 hin strömen, auf das Potential der Flächenelektrode 1 auflädt, bevor sie diese erreichen können.

Das am Ausgang 9 der Treiberstufe 7 beim Fließen eines Verschiebestroms auf die Flächenelektrode 1 erscheinende Signal ist, wie oben bereits erläutert wurde, ein Halbwellensignal, das durch den Kondensator 15 so weit geglättet werden kann, daß sofort ein Gleichspannungssignal zur Verfügung steht, ohne daß eine Demodulation erforderlich wäre.

Aus dem durch den Verstärker V1 verstärkten Gleichspannungssignal, das ein Maß für den Verschiebestrom darstellt, werden durch das Hochpaßfilter 16 die Gleichanteile eliminiert, die beispielsweise durch die durch Eis oder Tau verursachte kapazitive Kopplung gegen die auf Massepotential liegende Wand des Fahrzeugs entstehen können, so daß an den Eingang des Verstärkers V2 nur die vergleichsweise schnellen Änderungen des Gleichspannungssignals am Ausgang 9 der Treiberstufe 7 gelangen, die durch die Annäherung eines geerdeten Körpers an die Flächenelektrode 1 entstehen. Um den Eingang des nachfolgenden Verstärkers V2 gegen die negativen Unterschwinger des Hochpaßfilters16 zu schützen, kann parallel zum Widerstand 18 eine entsprechend gepolte Diode (nicht dargestellt) vorgesehen sein.

Andererseits werden durch das dem Verstärker V2 nachgeschaltete Tiefpaßfilter 20 kurze Störimpulse unterdrückt, die beispielsweise durch Funken an der Straßenbahnoberleitung, Funktelefone oder ähnliche Störstrahler entstehen können. Das so erhaltene, durch den Verstärker V3 nochmals verstärkte Signal wird dann dem einen Eingang des Komparators 25 zugeführt, der es mit einer durch den Spannungsteiler 26 vorgegebenen Referenzspannung vergleicht und bei deren Überschreiten ein Schaltsignal abgibt, das, wie bereits erwähnt, über den Ausgang 29 einer weiteren Verwendung zugeführt wird und gleichzeitig die Leuchtdiodenreihe 30 zum Verlöschen bringt und statt dessen die Leuchtdiodenreihe 32 aufleuchten läßt. Dies führt zu einem speziellen optischen Effekt, wie weiter unten unter Bezugnahme auf Fig.6 noch genauer erläutert wird.

Prinzipiell arbeitet die Ausführungsform nach Fig.3 in Verbindung mit Fig.2 in der gleichen Weise, wie dies eben beschrieben wurde, mit dem Unterschied, daß zur Gewinnung des Schaltsignals auch der auf die Ringelektrode 2 bei Annäherung eines geerdeten Körpers fließende Verschiebestrom erfaßt wird. Ein Halbwellensignal, das ein Maß für diesen Verschiebestrom darstellt, erscheint am weiteren Ausgang 9' der Treiberstufe 8', die in gleicher Weise arbeitet, wie dies oben für die Treiberstufe 7 beschrieben wurde. Die Differenz der an den Ausgängen 9, 9' erscneinenden und durch die Kondensatoren 15, 15' geglätteten Halbwellensignale wird durch den Differenzverstärker 37 ermittelt, der dann den Verstärker V1 mit einem entsprechenden Gleichspannungssignal versorgt.

Hier hat die Ringelektrode 2 also nicht nur die oben beschriebene abschirmende Wirkung, sondern ermöglicht es darüber hinaus, statt des Verschiebestroms der Flächenelektrode 1 gegen Erde die Differenz der beiden Verschiebeströme auszuwerten, wodurch die Grundkapazitäten der Flächenelektrode 1 und der Ringelektrode 2 gegenüber der unmittelbaren Umgebung voneinander subtrahiert und in ihrem Einfluß vermindert werden. Die beiden Grundkapazitäten müssen dabei nicht gleich sein. Außerdem wird eine Vorbedämpfung des Schalters durch Eis oder Schmutz vermindert. Auch wirken von außen kommende elektromagnetische Störungseinstrahlungen auf die beiden Elektroden in gleicher Weise und werden somit durch die Differenzbildung reduziert.

Da der Sensor im eingebauten Zustand immer eine Grundkapazität mißt, die nach dem Einschalten der Versorgungsspannung zu einem Impuls führt, kann der Verstärker V3 als Differenzverstärker ausgebildet sein (nicht dargestellt), dessen zweitem Eingang eine an einem zwischen seinen Ausgang und Masse gelegten Spannungsteiler abgegriffene Spannung zugeführt wird, wobei zum oberen der beiden den Spannungsteiler bildenden Widerstände ein Kondensator parallel geschaltet ist. Mit dieser Schaltungsanordnung kann die Schaltschwelle des Komparators nach dem Einschalten langsam auf die benötigte Empfindlichkeit heruntergefahren werden.

Fig.6 zeigt eine Draufsicht auf einen kapazitiven Schalter, bei dem die zentrale Flächenelektrode 1 mit einem Piktogramm versehen ist, das einen Rollstuhlfahrer wiedergibt. Wie man sieht, ist die kreisförmige Flächenelektrode 1 von einer kreisringförmigen Ringelektrode 2 umgeben. Außerdem sind auf einer konzentrischen Kreislinie acht Leuchtdioden-Paare 50 so angeordnet, daß die das jeweilige Paar bildenden Leuchtdioden mit einem möglichst kleinen Winkelabstand nebeneinander liegen, während die Winkelabstände zwischen den Leuchtdioden-Paaren erheblich größer sind. Die jeweils ein Paar 50 bildenden Leuchtdioden haben unterschiedliche Farben und eine von ihnen gehört jeweils zu der unter Bezugnahme auf Fig.1 beschriebenen Leuchtdiodenreihe 30, während die andere zur Leuchtdiodenreihe 32 gehört.

Ist die Leuchtdiodenreihe 30 (grün) über den Eingang 34 aktiviert (siehe Fig.1) so sieht eine Bedienungsperson zunächst nur einen Ring von grün leuchtenden Dioden. Wenn bei der Betätigung des kapazitiven Schalters der Umschalter 28 die grünen Leuchtdioden 30 von der Stromquelle 31 trennt und mit ihr statt dessen die roten Leuchtdioden 32 verbindet, so verlischt in jedem Paar 50 die grüne Leuchtdiode und es leuchtet die daneben liegende rote Leuchtdiode auf. Dies führt nicht nur zu einem Farbwechsel sondern erzeugt auch der optische Effekt einer Drehbewegung, wodurch die Erkennbarkeit erheblich gesteigert wird. Dies ist insbesondere dann von Bedeutung, wenn die Betätigungsfläche des kapazitiven Schalters durch Eis oder Schmutz teilweise verdeckt ist.

Kapazitive Schalter der hier beschriebenen Art werden im allgemeinen so aufgebaut, daß die Flächenelektrode 1 auf der ebenen Bodenfläche eines Bechers aus durchsichtigem isolierenden Material aufliegt, wobei die Außenseite dieser Bodenfläche im eingebauten Zustand der Bedienungsperson zugewandt ist, so daß sich das in Fig.6 gezeigte Aussehen ergibt. In geringem Abstand hinter der Flächenelektrode 1 und parallel zu ihr ist in den erwähnten Becher die Schaltungsplatine eingebaut, welche die beschriebene Schaltungsanordnung trägt. Auf diese Weise kann die gesamte Anordnung zu einer weitgehend gegen versehentliche oder mutwillige Beschädigungen gesicherten Einheit vergossen werden, aus der lediglich die Anschlüsse für die Stromversorgung und die Weitergabe des bei Betätigung des kapazitiven Schalters ausgelösten Schaltsignals herausragen.

Durch diesen Aufbau ergibt sich ein konstanter kapazitiver Verschiebestrom, der eine "Grundkapazität" simuliert. Je höher diese Grundkapazität ist, desto kleiner wird der Meßbereich des Schalters, da die interne Spannung begrenzt ist. Diese Grundkapazität ist um so höher, je näher die beiden Platinen aneinander liegen. Insbesondere bei der Montage an der Außenwand eines Fahrzeugs ist es wichtig, daß der Schalter möglichst flach aufgebaut ist. Zusätzlich fordert eine behindertengerechte Gestaltung größere Schalter, so daß die Grundkapazität einen großen Teil des Meßbereichs nehmen würde. Um hier Abhilfe zu schaffen, ist die Platine, welche auf der der Bedienungsperson zugewandten Seite die Flächenelektrode 1 trägt, auf ihrer Rückseite elektrisch leitend beschichtet. Diese Beschichtung ist mit der Ringelektrode 2 elektrisch leitend verbunden. Auf diese Weise wird die Kopplung zwischen der empfindlichen Flächenelektrode 1 und der Schaltungselektronik verringert.

## Patentansprüche

1. Schaltungsanordnung für einen kapazitiven Schalter, der einen Oszillator und eine Flächenelektrode umfaßt, deren Kapazität sich bei Annäherung eines geerdeten Körpers ändert, wobei der Oszillator (4) bei Annäherung eines geerdeten Körpers an die Flächenelektrode (1) mit unveränderter Amplitude und Frequenz weiterschwingt und die Schaltungsanordnung den auf die Flächenelektrode (1) fließenden Verschiebestrom erfaßt und in ein die Betätigung des kapazitiven Schalters anzeigendes Signal umsetzt, **dadurch gekennzeichnet, daß** das Signal des konstant schwingenden Oszillators (4) der Flächenelektrode (1) mittels einer Treiberstufe (7) über einen ersten Ausgang zugeführt wird, und an einem zweiten Ausgang (9) der Treiberstufe (7) ein Signal erscheint, das den auf die Flächenelektrode (1) fließenden Verschiebestrom wiedergibt.

2. Schaltungsanordnung nach Anspruch 1, **dadurch gekennzeichnet, daß** die Flächenelektrode (1) von einer Ringelektrode (2) umgeben ist, der das Signal des konstant schwingenden Oszillators (4) ebenfalls über eine Treiberstufe (8, 8') zugeführt wird.

3. Schaltungsanordnung nach Anspruch 2, **dadurch gekennzeichnet, daß** auch die Treiberstufe (8, 8Q der Ringelektrode (2) einen zweiten Ausgang (9') besitzt, an dem ein Signal erscheint, das den auf die Ringelektrode (2) fließenden Verschiebestrom wiedergibt

4. Schaltungsanordnung nach Anspruch 2 oder 3, **dadurch gekennzeichnet, daß** das am zweiten Ausgang (9, 9') der Treiberstufe (7, 8, 8') erscheinende Signal ein Halbwellensignal ist, das die Stromaufnahme der Treiberstufe (7, 8, 8') repräsentiert, die sich beim Fließen eines Verschiebestroms auf die betreffende Elektrode (1, 2) in Abhängigkeit von diesem ändert

5. Schaltungsanordnung nach Anspruch 4, **dadurch gekennzeichnet, daß** zwischen den zweiten Ausgang (9, 9') der Treiberstufe (7, 8, 8') und Masse ein Glättungskondensator (15, 15') für das Halbwellensignal geschaltet ist

6. Schaltungsanordnung nach einem der Ansprüche 1 bis 5, **dadurch gekennzeichnet, daß** die jeweilige Treiberstufe (7, 8, 8') im wesentlichen aus einer Gegentaktschaltung mit zwei mit ihren Kollektor-Emitter-Strecken in Reihe geschalteten Transistoren (40, 41) besteht, deren Basis-Anschlüsse gemeinsam mit dem Signal des Oszillators (4) angesteuert werden, wobei am Verbindungspunkt der Kollektor-Emitter-Strecken das Ansteuersignal für die betreffende Elektrode (1, 2) abgegriffen wird.

7. Schaltungsanordnung nach Anspruch 6, **dadurch gekennzeichnet, daß** die Reihenschaltung der beiden Transistoren (40, 41) mit einem Widerstand (42) in Reihe liegt, wobei der Verbindungspunkt zwischen dem einen der beiden Transistoren (40, 41) und dem Widerstand (42) den zweiten Ausgang (9, 9') der Treiberstufe (7, 8, 8') bildet

8. Schaltungsanordnung nach einem der Ansprüche 1 bis 5, **dadurch gekennzeichnet, daß** die Treiberstufe (7, 8, 8') im wesentlichen aus einem Operationsverstärker (45) besteht, dessen Eingang das Oszillatorsignal zugeführt wird und dessen Ausgang das Ansteuersignal für die betreffende Elektrode (1, 2) liefert.

9. Schaltungsanordnung nach Anspruch 8, **dadurch gekennzeichnet, daß** einer der beiden Stromversorgungsanschlüsse des Operationsverstärkers (45) mit einem Widerstand (47) in Reihe gestaltet ist und daß der Verbindungspunkt dieser Reihenschaltung der zweite Ausgang (9, 9') der Treiberstufe ist

10. Schaltungsanordnung nach einem der Ansprüche 1 bis 9, **dadurch gekennzeichnet, daß** zwischen den die betreffende Elektrode (1, 2) ansteuemden Ausgang der Treiberstufe (7, 8, 8') und die Elektrode (1, 2) ein Vorwiderstand (11, 12) gelegt ist, der die Treiberstufe (7, 8, 8') gegen elektrostatische Entladungen schützt.

11. Schaltungsanordnung nach einem der Ansprüche 1 bis 10, **dadurch gekennzeichnet, daß** das am zweiten Ausgang (9, 9') der Treiberstufe (7) der Flächenelektrode (1) erscheinende Signal über einen ersten Verstärker (V1) einem Hochpaßfilter (16) zugeführt wird.

12. Schaltungsanordnung nach einem der Ansprüche 3 bis 10, **dadurch gekennzeichnet, daß** die an den zweiten Ausgängen (9, 9') der beiden Treiberstufen (7, 8, 8') erscheinenden Signale den beiden Eingängen eines Differenzverstärkers (37) zugeführt werden, dessen Ausgang ein Hochpaßfilter (16) ansteuert

13. Schaltungsanordnung nach Anspruch 11 oder 12, **dadurch gekennzeichnet, daß** das Ausgangssignal des Hochpaßfilters (16) über einen zweiten Verstärker (V2) einem Tiefpaßfilter (20) zugeführt wird.

14. Schaltungsanordnung nach Anspruch 13, **dadurch gekennzeichnet, daß** das Ausgangssignal des Tiefpaßfilters (20) über einen dritten Verstärker (V3) dem einen Eingang eines Komparators (25) zugeführt wird, an dessen anderen Eingang eine Referenzspannung angelegt ist, bei deren Überschreiten durch das Signal am ersten Eingang der Komparator (25) ein die Betätigung des kapazitiven Schalters anzeigendes Schaltsignal abgibt.

15. Schaltungsanordnung nach einem der vorhergehenden Ansprüche, **dadurch gekennzeichnet, daß** der Oszillator (4) ein Sinussignal abgibt.

16. Schaltungsanordnung nach einem der Ansprüche 1 bis 14, **dadurch gekennzeichnet, daß** der Oszillator (4) ein Rechteckssignal abgibt.

17. Schaltungsanordnung nach einem der vorhergehenden Ansprüche, **dadurch gekennzeichnet, daß** das vom Komparator (25) abgegebene Schaltsignal einem Umschalter (28) zugeführt wird, der in Antwort hierauf aus einer Ruhestellung, in der er wenigstens eine Leuchtdiode (30) mit einer ersten Farbe mit einer Stromquelle (31) verbindet, so daß diese Leuchtdiode (30) leuchtet, in eine Arbeitsstellung übergeht, in der er die Leuchtdiode (30) mit der ersten Farbe von der Stromquelle (31) trennt, so daß die Leuchtdiode (30) verlischt, und wenigstens eine weitere Leuchtdiode (32) mit einer zweiten Farbe mit der Stromquelle (31) verbindet, so daß die weitere Leuchtdiode (32) mit der zweiten Farbe aufleuchtet.

18. Schaltungsanordnung nach Anspruch 17, **dadurch gekennzeichnet, daß** mehrere Leuchtdioden (30) der ersten Farbe und mehrere Leuchtdioden (32) der zweiten Farbe jeweils miteinander zu einer Gruppe verschaltet sind und diese beiden Diodengruppen durch den Umschalter (28) gegensinnig zum Aufleuchten bzw. Verlöschen gebracht werden.

19. Schaltungsanordnung nach Anspruch 18, **dadurch gekennzeichnet, daß** jeweils eine Leuchtdiode (30) der ersten Farbe in unmittelbarer Nähe einer Leuchtdiode (32) der zweiten Farbe angeordnet ist und diese Leuchtdioden-Paare auf einer zum Umfang der Flächenelektrode (1) parallel verlaufenden Linie mit großen Abständen gleichmäßig verteilt angeordnet sind.

20. Schaltungsanordnung nach einem der Ansprüche 2 bis 19, **dadurch gekennzeichnet, daß** die Flächenelektrode (1) und die Ringelektrode (2) auf der gleichen Seite einer flachen Trägerplatine angeordnet sind, deren Rückseite mit einer elektrisch leitenden Schicht bedeckt ist, die mit der Ringelektrode (2) in elektrisch leitender Verbindung steht.

## Claims

1. A circuit arrangement for a capacitive switch which includes an oscillator and a surface electrode whose capacitance changes upon the approach of an earthed body, wherein upon the approach of an earthed body to the surface electrode (1) the oscillator (4) continues to oscillate at unchanged amplitude and frequency and the circuit arrangement detects the displacement current flowing on to the surface electrode (1) and converts it into a signal indicating actuation of the capacitive switch, **characterised in that** the signal of the constantly oscillating oscillator (4) is fed to the surface electrode (1) by means of a driver stage (7) by way of a first output and a signal which reproduces the displacement current flowing on to the surface electrode (1) appears at a second output (9) of the driver stage (7).

2. A circuit arrangement according to claim 1 **characterised in that** the surface electrode (1) is surrounded by a ring electrode (2) to which the signal of the constantly oscillating oscillator (4) is also fed by way of a driver stage (8, 8').

3. A circuit arrangement according to claim 2 **characterised in that** the driver stage (8, 8') of the ring electrode (2) also has a second output (9') at which there appears a signal which reproduces the displacement current flowing on to the ring electrode (2).

4. A circuit arrangement according to claim 2 or claim 3 **characterised in that** the signal appearing at the second output (9, 9') of the driver stage (7, 8, 8') is a half-wave signal which represents the current consumption of the driver stage (7, 8, 8') which when a displacement current flows on to the electrode (1, 2) in question changes in dependence on said current.

5. A circuit arrangement according to claim 4 **characterised in that** a smoothing capacitor (15, 15') for the half-wave signal is connected between the second output (9, 9') of the driver stage (7, 8, 8') and earth.

6. A circuit arrangement according to one of claims 1 to 5 **characterised in that** the respective driver stage (7, 8, 8') substantially comprises a push-pull circuit with two transistors (40, 41) which are connected in series with their collector-emitter paths and the base terminals of which are actuated jointly with the signal of the oscillator (4), wherein the actuating signal for the electrode (1, 2) in question is taken off at the connecting point of the collector-emitter paths.

7. A circuit arrangement according to claim 6 **characterised in that** the series circuit of the two resistors (40, 41) is connected in series with a resistor (42), wherein the connecting point between one of the two transistors (40, 41) and the resistor (42) forms the second output (9, 9') of the driver stage (7, 8, 8').

8. A circuit arrangement according to one of claims 1 to 5 **characterised in that** the driver stage (7, 8, 8') substantially comprises an operational amplifier (45) to the input of which the oscillator signal is fed and the output of which provides the actuating signal for the electrode (1, 2) in question.

9. A circuit arrangement according to claim 8 **characterised in that** one of the two power supply terminals of the operational amplifier (45) is connected in series with a resistor (47) and that the connecting point of said series circuit is the second output (9, 9') of the driver stage.

10. A circuit arrangement according to one of claims 1 to 9 **characterised in that** connected between the electrode (1, 2) and the output of the driver stage (7, 8, 8') which actuates the electrode (1, 2) in question is a series resistor (11, 12) which protects the driver stage (7, 8, 8') from electrostatic discharges.

11. A circuit arrangement according to one of claims 1 to 10 **characterised in that** the signal appearing at the second output (9, 9') of the driver stage (7) of the surface electrode (1) is fed to a high pass filter (16) by way of a first amplifier (V1).

12. A circuit arrangement according to one of claims 3 to 10 **characterised in that** the signals appearing at the second outputs (9, 9') of the two driver stages (7, 8, 8') are fed to the two inputs of a differential amplifier (37) whose output actuates a high pass filter (16).

13. A circuit arrangement according to claim 11 or claim 12 **characterised in that** the output signal of the high pass filter (16) is fed to a low pass filter (20) by way of a second amplifier (V2).

14. A circuit arrangement according to claim 13 **characterised in that** the output signal of the low pass filter (20) is fed by way of a third amplifier (V3) to the one input of a comparator (25), to the other input of which is applied a reference voltage, wherein when the signal at the first input exceeds the reference voltage the comparator (25) outputs a switching signal indicating actuation of the capacitive switch.

15. A circuit arrangement according to one of the preceding claims **characterised in that** the oscillator (4) outputs a sinusoidal signal.

16. A circuit arrangement according to one of claims 1 to 14 **characterised in that** the oscillator (4) outputs a square-wave signal.

17. A circuit arrangement according to one of the preceding claims **characterised in that** the switching signal outputted by the comparator (25) is fed to a change-over switch (28) which in response thereto changes from a rest position in which it connects at least one light emitting diode (30) of a first colour to a current source (31) so that said light emitting diode (30) lights into a working position in which it separates the light emitting diode (30) of the first colour from the current source (31) so that the light emitting diode (30) extinguishes, and connects at least one further light emitting diode (32) of a second colour to the current source (31) so that the further light emitting diode (32) lights up with the second colour.

18. A circuit arrangement according to claim 17 **characterised in that** a plurality of light emitting diodes (30) of the first colour and a plurality of light emitting diodes (32) of the second colour are connected together to form respective groups and said two groups of diodes can be caused to light up and extinguish in opposite relationship by the change-over switch (28).

19. A circuit arrangement according to claim 18 **characterised in that** in each case a light emitting diode (30) of the first colour is arranged in the immediate proximity of a light emitting diode (32) of the second colour and said pairs of light emitting diodes are arranged uniformly distributed at large spacings on a line extending parallel to the periphery of the surface electrode (1).

20. A circuit arrangement according to one of claims 2 to 19 **characterised in that** the surface electrode (1) and the ring electrode (2) are arranged on the same side of a flat support board, the rear side of which is covered with an electrically conductive layer which is electrically conductively connected to the ring electrode (2).

## Revendications

1. Circuit pour un interrupteur capacitif comprenant un oscillateur et une électrode de jonction, dont la capacité change à l'approche d'un corps mis à la masse de sorte que l'oscillateur (4) continue d'osciller avec la même amplitude et fréquence à l'approche de l'électrode de jonction (1) d'un corps mis à la masse, ledit circuit collectant le courant de déplacement qui circule sur l'électrode de jonction (1) afin de le transformer en un signal témoin de la commande d'amorçage de l'interrupteur capacitif, sachant que le signal de l'oscillateur (4) de l'électrode de jonction (1) qui oscille de manière constante est acheminé à l'aide d'un étage d'excitation (7) vers une première sortie, et qu'un signal apparaît à une deuxième sortie (9) de l'étage d'excitation (7), lequel restitue le courant de déplacement qui circule sur l'électrode de jonction (1).

2. Circuit selon la revendication 1, **caractérisé en ce que** l'électrode de jonction (1) est entourée d'une électrode annulaire (2), le signal de l'oscillateur (4) qui oscille de manière constante étant également acheminé vers cette dernière via un étage d'excitation (8,8').

3. Circuit selon la revendication 2, **caractérisé en ce que** l'étage d'excitation (8, 8') de l'électrode annulaire (2) possède également une deuxième sortie (9') à laquelle apparaît un signal qui restitue le courant de déplacement circulant sur l'électrode annulaire (2).

4. Circuit selon les revendications 2 ou 3, **caractérisé en ce que** le signal apparaissant à la deuxième sortie (9,9') de l'étage d'excitation (7, 8, 8') soit un signal demi-onde, lequel représente l'intensité absorbée par l'étage d'excitation (7, 8, 8'), laquelle se modifie en fonction du courant de déplacement qui circule sur ladite électrode (1, 2).

5. Circuit selon la revendication 4, **caractérisé en ce qu'**un condensateur de filtrage (15, 15') pour le signal en demi-onde soit branché entre la deuxième sortie (9, 9') de l'étage d'excitation (7, 8, 8') et la masse.

6. Circuit selon l'une des revendications 1 à 5, **caractérisé en ce que** chaque étage d'excitation (7, 8, 8') soit essentiellement formé d'un montage en opposition de phase comprenant deux transistors (40, 41) branchés en série via leurs liaisons collecteurs-détecteurs dont les raccordements de base sont commandés en même temps que le signal de l'oscillateur (4), sachant que le signal de commande d'amorçage pour l'électrode concernée (1, 2) est mesuré au point de transfert des liaisons collecteurs-détecteurs.

7. Circuit selon la revendication 6, **caractérisé en ce que** le montage en série des deux transistors (40, 41) inclut une résistance (42), sachant que le point de transfert entre l'un des deux transistors (40, 41) et la résistance (42) forme la deuxième sortie (9, 9') de l'étage d'excitation (7, 8, 8').

8. Circuit selon l'une des revendications 1 à 5, **caractérisé en ce que** l'étage d'excitation (7, 8, 8') se compose essentiellement d'un amplificateur d'opérations (45), le signal de l'oscillateur étant acheminé vers son entrée, sa sortie délivrant le signal de commande d'amorçage pour l'électrode concernée (1, 2).

9. Circuit selon la revendication 8, **caractérisé en ce que** l'une des deux alimentations en électricité de l'amplificateur d'opérations (45) soit branchée en série avec une résistance (47) et que le point de transfert de ce montage en série soit la deuxième sortie (9, 9') de l'étage d'excitation.

10. Circuit selon l'une des revendications 1 à 9, **caractérisé en ce qu'**une première résistance (11, 12) soit disposée entre la sortie de l'étage d'excitation (7, 8, 8') qui commande l'électrode concernée (1, 2) et cette électrode (1, 2), laquelle protège l'étage d'excitation (7 , 8, 8') des décharges électrostatiques.

11. Circuit selon une des revendications 1 à 10, **caractérisé en ce que** le signal apparaissant à la deuxième sortie (9, 9') de l'étage d'excitation (7) de l'électrode de jonction (1) soit acheminé vers un filtre passe-haut (16) via un premier amplificateur (V1).

12. Circuit selon une des revendication 3 à 10, **caractérisé en ce que** les signaux apparaissant à la deuxième sortie (9, 9') de chacun des deux étages d'excitation (7, 8, 8') soient acheminés vers les deux entrées d'un amplificateur différentiel (37), dont la sortie commande un filtre passe-haut (16).

13. Circuit selon les revendications 11 ou 12, **caractérisé en ce que** le signal de sortie du filtre passe-haut (16) soit acheminé via un deuxième amplificateur (V2) vers un filtre passe-bas (20).

14. Circuit selon la revendication 13, **caractérisé en ce que** le signal de sortie du filtre passe-bas (20) soit acheminé via un troisième amplificateur (V3) vers l'une des entrées d'un comparateur (25), une tension de référence étant constituée à l'autre entrée, de sorte qu'en cas de dépassement de cette dernière par le signal à la première entrée, le comparateur (25) émet un signal de commutation qui signale la commande d'amorçage de l'interrupteur capacitif.

15. Circuit selon l'une des revendications précédentes, **caractérisé en ce que** l'oscillateur (4) émet un signal sinusoïdal.

16. Circuit selon l'une des revendications 1 à 14, **caractérisé en ce que** l'oscillateur (4) émet un signal carré.

17. Circuit selon l'une des revendications précédentes, **caractérisé en ce que** le signal de commutation émis par le comparateur (25) soit acheminé vers un inverseur (28), lequel va passer de la position repos dans laquelle il relie au moins une diode lumineuse (30) d'une première couleur avec une source de courant (31) de sorte à la (30) faire briller, en position de travail en réponse à ce signal, de sorte qu'il sépare la diode lumineuse (30) de la première couleur de sa source de courant (31) afin de l'éteindre (30), et relie au moins une autre diode lumineuse (32) d'une deuxième couleur avec une source de courant (31) afin que cette dernière diode lumineuse (32) d'une deuxième couleur se mette à briller.

18. Circuit selon la revendication 17, **caractérisé en ce que** plusieurs diodes lumineuses (30) de la première couleur et plusieurs diodes lumineuses (32) de la deuxième couleur soient respectivement branchées en groupes et que ces deux groupes de diodes s'allument et s'éteignent à tour de rôle sous l'action de l'inverseur (28).

19. Circuit selon la revendication 18, **caractérisé en ce qu'**une diode lumineuse (30) de la première couleur soit toujours disposée à proximité d'une diode lumineuse (32) de la deuxième couleur et que ces paires de diodes lumineuses soient réparties de manière homogène en respectant un écart important sur une ligne parallèle à l'étendue de l'électrode de jonction (1).

20. Circuit selon l'une des revendications 2 à 19, **caractérisé en ce que** l'électrode de jonction (1) et l'électrode annulaire (2) soient disposées sur une même face de la carte, la face arrière de cette dernière étant recouverte d'une couche conductrice laquelle se trouve en liaison électrique avec l'électrode annulaire (2).
